# EUROPEAN PATENT APPLICATION

(11) **EP 4 576 142 A2**
(43) Date of publication of application: **25.06.2025**
(21) Application number: 24189478.1
(22) Date of filing: 18.07.2024
(51) Int. Cl.: H01G 4/33, H01G 4/38, H01G 4/005, H01G 4/012, H01G 4/252, H01G 4/228, H10D 1/68

(54) **CAPACITOR**

(30) Priority: 21.12.2023 KR 20230188405
(71) Applicant: Samsung Electro-Mechanics Co., Ltd., Suwon-si, Gyeonggi-do (KR)
(72) Inventor: Park, Jihoon, 16674 Suwon-si, Gyeonggi-do (KR); Park, Gwangpyo, 16674 Suwon-si, Gyeonggi-do (KR); Choi, A Young, 16674 Suwon-si, Gyeonggi-do (KR); Jeong, Jaeyong, 16674 Suwon-si, Gyeonggi-do (KR); No, Daehee, 16674 Suwon-si, Gyeonggi-do (KR)
(74) Representative: Grünecker Patent- und Rechtsanwälte PartG mbB

(57) **Abstract**

A capacitor according to an aspect includes a structure that has a first surface where a plurality of openings are positioned, a first internal electrode that is disposed on at least a portion of the region where the plurality of openings are positioned, a floating electrode that is disposed on a partial region of the first internal electrode, a second internal electrode that is disposed on the floating electrode, a first external electrode that is disposed on the first surface and is connected to the first internal electrode, and a second external electrode that is disposed on the first surface and is connected to the second internal electrode.

## Description

### TECHNICAL FIELD

The present disclosure relates to a capacitor.

### BACKGROUND

Electronic components that are used in electronic devices include capacitors, inductors, piezoelectric devices, varistors, thermistors, and so on. Among ceramic electronic components, multilayer capacitors have the advantage that they are small, high capacitance is guaranteed, and it is easy to mount them, and thus can be used in a variety of electronic devices.

For example, multilayer capacitors may be used in chip-like capacitors that are mounted on substrates of various electronic products such as imaging devices, for example, liquid crystal displays (LCDs), plasma display panels (PDPs), and organic light-emitting diodes (OLEDs), computers, personal portable terminals, and smart phones so as to serve to charge or discharge.

With the recent trend toward smaller and thinner electronic products, the demand for capacitors which have higher capacity than conventional capacitors is increasing.

### SUMMARY

The present disclosure attempts to provide a capacitor with high capacity.

However, objects which the embodiments of the present invention attempt to achieve are not limited to the above-mentioned object, and can be variously expanded without departing from the technical spirit and scope of the present invention.

A capacitor according to an aspect may include a structure that has a first surface where a plurality of openings are positioned, a first internal electrode that is disposed on at least a portion of the region where the plurality of openings are positioned, a floating electrode that is disposed on a partial region of the first internal electrode, a second internal electrode that is disposed on the floating electrode, a first external electrode that is disposed on the first surface and is connected to the first internal electrode, and a second external electrode that is disposed on the first surface and is connected to the second internal electrode.

The structure may includes anodizing aluminum oxide.

The plurality of openings may include first openings, second openings, and third openings, and the first external electrode may face a region where the first openings are positioned, in a direction in which the first surface of the structure and a second surface of the structure are spaced apart from each other.

In the first openings, first opening side cavities may be positioned.

The first external electrode may be connected to the first internal electrode in a region positioned adjacent to the first openings.

The first external electrode may be in direct contact with the first internal electrode so as to be connected to the first internal electrode.

The capacitor may further include a first opening side insulating layer that covers the first openings.

The second external electrode may face a region where the second openings are positioned, in the direction in which the first surface and the second surface are spaced apart from each other.

The second external electrode may be connected to the second internal electrode in a region positioned adjacent to the second openings.

The second external electrode may be in direct contact with the second internal electrode so as to be connected to the second internal electrode.

In the second openings, second opening side cavities may be positioned.

The capacitor may further include a second opening side insulating layer that covers the second openings.

The floating electrode and the second internal electrode may be disposed on the second opening side insulating layer.

Among regions where the first, second, and third openings are positioned, the floating electrode and the second internal electrode may be disposed only on the regions where the second openings and the third openings are positioned.

Among regions where the first and second openings are positioned, the floating electrode and the second internal electrode may be disposed only on the region where the second openings are positioned.

The number of openings among the plurality of openings where the first internal electrode is disposed may be greater than the number of openings among the plurality of openings where the floating electrode and the second internal electrode are disposed.

A capacitor according to another aspect may include a structure that has a first surface where a plurality of openings is positioned, a first internal electrode that is disposed on regions between the plurality of openings on the first surface and the openings, a floating electrode that is disposed on the first internal electrode, a second internal electrode that is disposed on the floating electrode, a first external electrode that is connected to the first internal electrode and is disposed in a direction toward which the first surface of the structure faces, and a second external electrode that is connected to the second internal electrode and is disposed in the direction toward which the first surface of the structure faces.

The plurality of openings may include first openings, second openings, and third openings, and on the first openings and a region where the first openings are adjacent to each other, the floating electrode and the second internal electrode may not be present, and the first external electrode may be connected to the first internal electrode in a region positioned adjacent to the first openings.

The capacitor may further include a second opening side insulating layer that covers the second openings.

The plurality of openings may include first openings and second openings, and on the first openings and a region where the first openings are adjacent to each other, the floating electrode and the second internal electrode may not be present, and the first external electrode may be connected to the first internal electrode in a region positioned adjacent to the first openings.

According to at least one embodiment of the embodiments, a capacitor with high capacity can be provided.

### BRIEF DESCRIPTION OF THE DRAWINGS

FIG. 1 is a drawing illustrating a capacitor according to an embodiment.
FIG. 2 is a drawing illustrating a structure in FIG. 1.
FIG. 3 is a drawing illustrating region A in FIG. 1.
FIGS. 4 to 9 are drawings illustrating a method of manufacturing the capacitor according to the embodiment.
FIG. 10 is a drawing illustrating a capacitor according to another embodiment.

### DETAILED DESCRIPTION OF THE EMBODIMENTS

In the following detailed description, only certain embodiments of the present invention have been shown and described, simply by way of illustration. The present invention can be variously implemented and is not limited to the following embodiments.

The drawings and description are to be regarded as illustrative in nature and not restrictive. Like reference numerals designate like elements throughout the specification.

In addition, the size and thickness of each configuration shown in the drawings are arbitrarily shown for understanding and ease of description, but the present invention is not limited thereto. In the drawings, the thickness of layers, films, panels, regions, etc., are exaggerated for clarity. Further, in the drawings, for understanding and ease of description, the thickness of some layers and areas is exaggerated.

Further, it will be understood that when an element such as a layer, film, region, or substrate is referred to as being "on" another element, it can be directly on the other element or intervening elements may also be present. In contrast, when an element is referred to as being "directly on" another element, there are no intervening elements present. Further, when an element is "on" a reference portion, the element is located above or below the reference portion, and it does not necessarily mean that the element is located "above" or "on" in a direction opposite to gravity.

In addition, unless explicitly described to the contrary, the word "comprise", and variations such as "comprises" or "comprising", will be understood to imply the inclusion of stated elements but not the exclusion of any other elements.

Further, in the entire specification, when it is referred to as "on a plane", it means when a target part is viewed from above, and when it is referred to as "on a cross-section", it means when the cross-section obtained by cutting a target part vertically is viewed from the side.

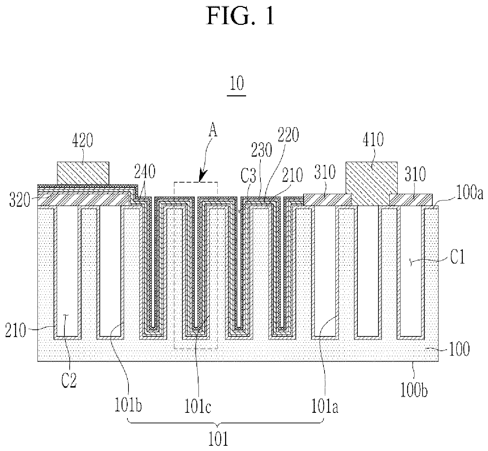

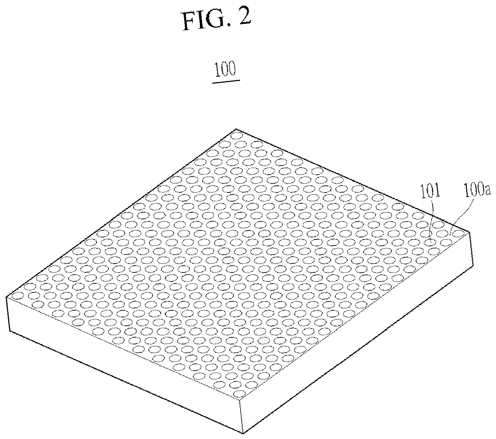

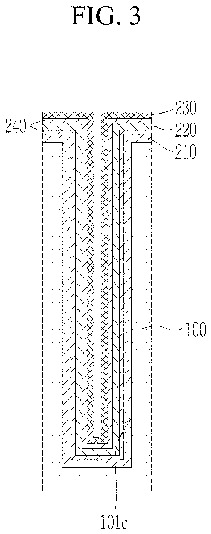

FIG. 1 is a drawing illustrating a capacitor 10 according to an embodiment, FIG. 2 is a drawing illustrating a structure 100 in FIG. 1, and FIG. 3 is a drawing illustrating region A in FIG. 1.

Referring to FIGS. 1 to 3, the capacitor 10 according to the embodiment may include the structure 100, a first internal electrode 210, a floating electrode 220, a second internal electrode 230, dielectric layers 240, a first external electrode 410, and a second external electrode 420.

The structure 100 has a first surface 100a and a second surface 100b positioned opposite to each other. In FIG. 1, it is shown that the first surface 100a is positioned on the upper side and the second surface 100b is positioned on the lower side. Accordingly, the first surface 100a may be referred to as the upper surface, and the second surface 100b may be referred to as the lower surface. Further, the direction in which the first surface 100a and the second surface 100b are spaced apart from each other may be referred to as a vertical direction. The structure 100 may be formed of an insulating material. The first surface 100a of the structure 100 has a plurality of openings 101. The openings 101 may be columnar spaces recessed from the first surface 100a toward the second surface 100b. As an example, the structure 100 may be formed of porous anodizing aluminum oxide (AAO), and the openings 101 may be formed by fine pores formed in the anodizing aluminum oxide. The aspect ratios of the fine pores may be in a range from 2000 to 3000. The structure 100 may have a structure in which the bottoms of the fine pores are blocked.

The first internal electrode 210 may be disposed on at least a portion of the region where the openings 101 are positioned. The first internal electrode 210 is disposed on the inner surfaces of the openings 101. Also, the first internal electrode 210 may be disposed on the sections between adjacent openings 101 on the first surface 100a of the structure 100. Accordingly, the regions of the first internal electrode 210 disposed on the inner surfaces of the openings 101 may be connected to each other by the regions position of the first surface 100a of the structure 100.

The openings 101 may include first openings 101a, second openings 101b, and third openings 101c. Among the plurality of openings 101, one or more are provided as first openings 101a. Further, among the plurality of openings 101, one or more are provided as second openings 101b. Furthermore, the remaining openings of the plurality of openings 101, other than the first openings 101a and the second openings 101b, may be provided as third openings 101c. The region where the first openings 101a are positioned and the region where the second openings 101b are positioned are spaced apart from each other, and the third openings 101c are positioned between the first openings 101a and the second openings 101b.

The first external electrode 410 may be disposed in the direction toward which the first surface 100a of the structure 100 faces. The first external electrode 410 is disposed on the first internal electrode 210 in the region where the first openings 101a are positioned. The first external electrode 410 may face the region where the first openings 101a are positioned, in the vertical direction. The first external electrode 410 may be disposed so as to be in contact with the first internal electrode 210 in a region located adjacent to the first openings 101a, thereby being electrically connected to the first internal electrode 210. The first external electrode 410 may be a single-layer structure or a multi-layer structure.

The first external electrode 410 may be disposed on the first internal electrode 210 disposed on a section between first openings 101a. The first external electrode 410 may cover one or more first openings 101a. Accordingly, in the first openings 101a positioned below the first external electrode 410, first opening side cavities C1 may be formed on the first internal electrode 210. Further, on the portions of the region on the first openings 101a, other than the region where the first external electrode 410 is disposed, a first opening side insulating layer 310 may be disposed. The first opening side insulating layer 310 may be disposed so as to cover some of the first openings 101a. The first opening side insulating layer 310 may cover some of a plurality of first openings 101a. Accordingly, in the first openings 101a positioned below the first opening side insulating layer 310, first opening side cavities C1 may be formed on the first internal electrode 210. The material of the first opening side insulating layer 310 may be polyimide or the like.

On the first internal electrode 210 in the region where the second openings 101b are positioned, a second opening side insulating layer 320 may be disposed. The second opening side insulating layer 320 may be disposed so as to cover the second openings 101b. Accordingly, in the second openings 101b, second opening side cavities C2 may be formed on the first internal electrode 210. The material of the second opening side insulating layer 320 may be polyimide or the like.

On the region where the second openings 101b are positioned, a floating electrode 220 may be disposed. The floating electrode 220 may be disposed on the second opening side insulating layer 320. Accordingly, on the region where the second openings 101b are positioned, the floating electrode 220 may be disposed on the first internal electrode 210 and the second opening side insulating layer 320 may be disposed between the first internal electrode 210 and the floating electrode 220.

Also, the floating electrode 220 may be disposed on the first internal electrode 210 in the region where the third openings 101c are positioned. In the region where the third openings 101c are positioned, the floating electrode 220 may be formed on the inner regions of the third openings 101c and the sections between the third openings 101c adjacent to each other on the first surface 100a of the structure 100.

In the floating electrode 220, the portion formed on the region where the second openings 101b are positioned may be connected to the portion formed on the region where the third openings 101c are positioned.

The floating electrode 220 may not be on the first internal electrode 210 in the region where the first openings 101a are positioned. In other words, the floating electrode 220 may not be formed on the first openings 101a and the first internal electrode 210 disposed on the region on the first surface 100a between first openings 101a adjacent to each other.

Further, the floating electrode 220 may be formed on a plurality of layers.

On the floating electrode 220, the second internal electrode 230 is disposed. In other words, the second internal electrode 230 may be disposed on the region where the second openings 101b are positioned and the region where the third openings 101c are positioned. In the region where the third openings 101c are positioned, the second internal electrode 230 may be formed on the inner regions of the third openings 101c and the sections on the second surface 100b of the structure 100 between the third openings 101c adjacent to each other. In the third openings 101c, third opening side cavities C3 may be formed on the second internal electrode 230. Alternatively, the second internal electrode 230 may be disposed so as to fill the third openings 101c, such that the third openings 101c do not have third opening side cavities C3.

The second internal electrode 230 is not on the first internal electrode 210 in the region where the first openings 101a are positioned.

The dielectric layers 240 are disposed only on some portions of the first internal electrode 210. The dielectric layers 240 may be disposed only on the regions where the second openings 101b and the third openings 101c are positioned.

In the regions where the second openings 101b and the third openings 101c are positioned, the dielectric layers 240 may be disposed between the first internal electrode 210 and the floating electrode 220. In the region where the second openings 101b are positioned, the dielectric layers 240 may be disposed on the second opening side insulating layer 320. Accordingly, in the region where the second openings 101b are positioned, the dielectric layers 240 may be disposed between the floating electrode 220 and the second opening side insulating layer 320. Further, in the region where the second openings 101b are positioned, the second opening side insulating layer 320 may be disposed between the first internal electrode 210 and the dielectric layers 240. In the region where the third openings 101c are positioned, the dielectric layers 240 may be disposed between the first internal electrode 210 and the floating electrode 220.

Furthermore, when the floating electrode 220 includes a plurality of layers, the dielectric layers 240 may be disposed between the layers of the floating electrode 220.

Between the floating electrode 220 and the second internal electrode 230, the dielectric layers 240 are disposed. In the region where the second openings 101b are positioned, a dielectric layer 240 may be disposed between the floating electrode 220 and the second internal electrode 230. In the region where the third openings 101c are positioned, a dielectric layer 240 may be disposed between the floating electrode 220 and the second internal electrode 230.

The dielectric layers 240 may not be on the first internal electrode 210 in the region where the first openings 101a are positioned. In other words, the dielectric layers 240 may not be formed on the first openings 101a and the first internal electrode 210 disposed in the regions of the first surface 100a between the first openings 101a adjacent to each other.

The second external electrode 420 may be disposed in the direction toward which the first surface 100a of the structure 100 faces. The second external electrode 420 is disposed apart from the first external electrode 410. The second external electrode 420 is disposed on the second internal electrode 230. The second external electrode 420 may be disposed so as to be in contact with the second internal electrode 230, thereby being electrically connected to the second internal electrode 230. The second external electrode 420 may be disposed on the region where the second openings 101b are positioned, so as to face the region where the second openings 101b are positioned, in the vertical direction. Accordingly, below the second external electrode 420, the second opening side insulating layer 320 and the second opening side cavities C2 may be positioned. The second external electrode 420 may be a single-layer structure or a multi-layer structure.

In the capacitor 10 according to the embodiment, most of the first internal electrode 210 and the second internal electrode 230 are disposed on the openings 101. For convenience, in FIGS. 1 to 3, only some of the openings 101 are shown; however, a very large number of openings 101 are positioned as nanostructures in the structure 100 which is anodizing aluminum oxide (AAO). Accordingly, on a plane intersecting the direction in which the first surface 100a and second surface 100b of the structure 100 face each other, the surface area of the first internal electrode 210 and the second internal electrode 230 is very large with respect to the area occupied by the structure 100. As a result, the capacitor 10 according to the embodiment has very high capacity relative to its size.

Further, in the capacitor 10 according to the embodiment, the floating electrode 220 is disposed between the first internal electrode 210 and the second internal electrode 230. Specifically, on the regions where the second openings 101b and the third openings 101c are positioned, the floating electrode 220 is disposed between the first internal electrode 210 and the second internal electrode 230. Accordingly, the voltage difference between the first internal electrode 210 and the second internal electrode 230 is distributed by the floating electrode 220. Specifically, the voltage difference between the first internal electrode 210 and the second internal electrode 230 is caused by the voltage difference between the first internal electrode 210 and the floating electrode 220 and the voltage difference between the floating electrode 220 and the second internal electrode 230. Accordingly, in the capacitor 10 according to the embodiment, the magnitude of the breakdown voltage increases and thus the possibility of a breakdown phenomenon occurring significantly decreases.

Furthermore, in the capacitor 10 according to the embodiment, the cavities C1 and C2 may be formed inside the openings 101 positioned below the external electrodes 410 and 420. These cavities C1 and C2 may prevent cracks from being caused in the internal electrodes 210 and 230, the dielectric layers 240, and the like by a force (for example, vibration or compression) that is applied to the external electrodes 410 and 420 and under the external electrodes 410 and 420 in the process of mounting the capacitor 10.

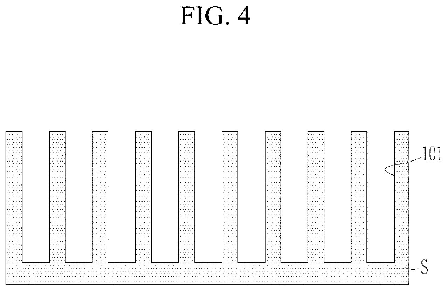

FIGS. 4 to 9 are drawings illustrating a method of manufacturing the capacitor 10 according to the embodiment.

Hereinafter, the method of manufacturing the capacitor 10 according to the embodiment will be described with reference to FIGS. 4 to 9.

Referring to FIG. 4, a substrate S to form the structure 100 is provided. The substrate S is provided with a plurality of openings 101 formed therein. The substrate S may be provided so as to have an area capable of accommodating two or more capacitors 10. The substrate S may be formed of anodizing aluminum oxide (AAO), and the openings 101 may be fine pores formed by an anodization method. In this case, the openings 101 are provided in a downwardly blocked state. The diameters of the openings 101 may be in a range from 50 nm to 300 nm. The diameters of the openings 101 may be diameters measured from the upper ends of the openings 101.

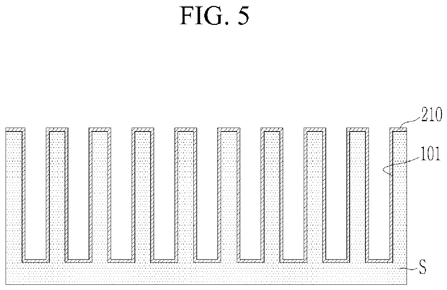

Referring to FIG. 5, on the region of the structure 100 where the openings 101 are positioned, the first internal electrode 210 is formed. The first internal electrode 210 is formed on the inner surfaces of the openings 101. Also, the first internal electrode 210 is formed on the regions where the openings 101 are adjacent to each other. Accordingly, the first internal electrode 210 is continuously formed. The first internal electrode 210 may be formed by a deposition process. Chemical vapor deposition (CVD), atomic layer deposition (ALD), and the like may be used to form the first internal electrode 210. The first internal electrode 210 may be formed to a thickness of several nanometers to several tens of nanometers. The first internal electrode 210 may be formed of TiN or the like.

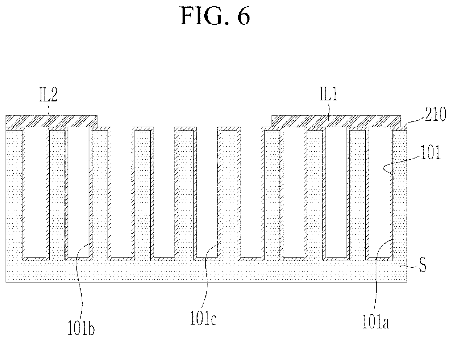

Referring to FIG. 6, a first insulating layer IL1 is formed on the region where the first openings 101a are positioned, and a second insulating layer IL2 is formed on the region where the second openings 101b are positioned. As an example, a mask in which regions where the first insulating layer IL1 and the second insulating layer IL2 are to be formed are open may be formed on the structure 100 by a photolithography process. Then, the first insulating layer IL1 and the second insulating layer IL2 may be formed on the structure 100 through the mask. The first insulating layer IL1 and the second insulating layer IL2 may be formed by a deposition process. Chemical vapor deposition (CVD), atomic layer deposition (ALD), or the like may be used to form the first insulating layer IL1 and the second insulating layer IL2. Thereafter, the mask may be removed by a strip process.

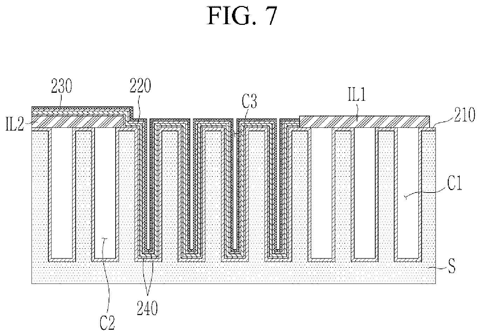

Referring to FIG. 7, on the region where the second openings 101b are positioned and the region where the third openings 101c are positioned, a dielectric layer 240, the floating electrode 220, another dielectric layer 240, and the second internal electrode 230 are sequentially formed.

Each of a dielectric layer 240, the floating electrode 220, another dielectric layer 240, and the second internal electrode 230 is formed simultaneously on the region where the second openings 101b are positioned and the region where the third openings 101c are positioned. Accordingly, in each of a dielectric layer 240, the floating electrode 220, another dielectric layer 240, and the second internal electrode 230 sequentially formed, the portion on the region where the second openings 101b are positioned is connected to the portion on the region where the third openings 101c are positioned.

A dielectric layer 240, the floating electrode 220, another dielectric layer 240, and the second internal electrode 230 are formed on the second insulating layer IL2. Further, a dielectric layer 240, the floating electrode 220, another dielectric layer 240, and the second internal electrode 230 are formed on the inner surfaces of the third openings 101c and the sections between the third openings 101c adjacent to each other.

The dielectric layers 240 may be formed by a deposition process. Chemical vapor deposition (CVD), atomic layer deposition (ALD), and the like may be used to form the dielectric layers 240. The dielectric layers 240 may be formed of one of metal oxides such as Al₂O₃, ZrO₂, HfO₂, etc. Alternatively, the dielectric layers 240 may be formed of a combination of metal oxides such as Al₂O₃, ZrO₂, HfO₂, etc. Also, the dielectric layers 240 may be formed of a ZAZ layer which is a composite layer of a ZrO₂ layer, an Al₂O₃ layer, and a ZrO₂ layer. In this case, the thicknesses of each of the ZrO₂, Al₂O₃, and ZrO₂ layers may be in a range from 1.9 nm to 2.1nm, a range from 0.29 nm to 0.31nm, and a range from 1.9 nm to 2.1nm, respectively.

The floating electrode 220 may be formed by a deposition process. Chemical vapor deposition (CVD), atomic layer deposition (ALD), and the like may be used to form the floating electrode 220. The floating electrode 220 may be formed of TiN or the like.

The second internal electrode 230 may be formed by a deposition process. Chemical vapor deposition (CVD), atomic layer deposition (ALD), and the like may be used to form the second internal electrode 230. The second internal electrode 230 may be formed of TiN or the like.

The second internal electrode 230 may be formed so as not to fully fill the insides of the third openings 101c such that in the third openings 101c, the third opening side cavities C3 are formed on the second internal electrode 230. Alternatively, the second internal electrode 230 may be formed so as to fill the third openings 101c, such that the third openings 101c do not have the third opening side cavities C3.

By the first insulating layer IL1, the dielectric layer 240, the floating electrode 220, another dielectric layer 240, and the second internal electrode 230 are prevented from being deposited on the inner sides of the first openings 101a. Inside the first openings 101a positioned below the first insulating layer IL1, the first opening side cavities C1 are formed.

By the second insulating layer IL2, the dielectric layer 240, the floating electrode 220, another dielectric layer 240, and the second internal electrode 230 are prevented from being deposited on the inner sides of the second openings 101b. Inside the second openings 101b positioned below the second insulating layer IL2, the second opening side cavities C2 are formed.

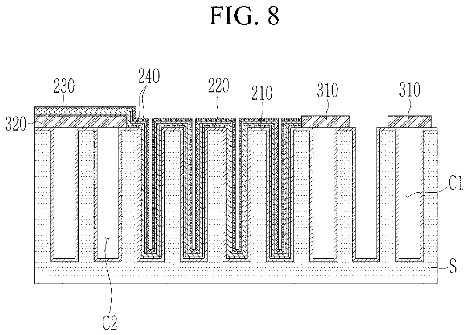

Referring to FIG. 8, a portion of the first insulating layer IL1 is etched, such that the first opening side insulating layer 310 are formed. Further, from the regions where the first insulating layer IL1 is etched, the first internal electrode 210 is exposed to the outside. The process of etching the first insulating layer IL1 may be performed after a mask in which the etch region is open is formed by a photolithography process. Further, the second insulating layer IL2 becomes the second opening side insulating layer 320.

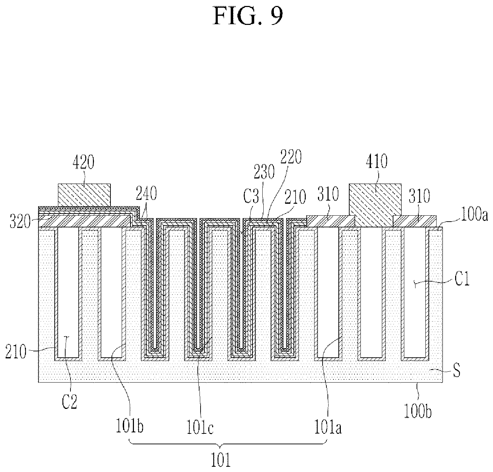

Referring to FIG. 9, the first external electrode 410 and the second external electrode 420 are formed. The first external electrode 410 may be formed on the first internal electrode 210 exposed to the outside in the region where the first openings 101a are positioned. The second external electrode 420 may be formed on the second internal electrode 230. The second external electrode 420 may be formed on the region where the second openings 101b are positioned. As an example, the first external electrode 410 and the second external electrode 420 may have a multi-layer structure by forming seed layers and then forming the other portions on the seed layers. The seed layers may be formed of a metal material such as Ti, Cu, etc. The seed layers may be formed by a sputtering process. The other portions that are formed on the seed layers may be formed by a plating process using Cu, Sn, Ag, etc.

Thereafter, the substrate S may be diced such that the regions where individual capacitors 10 are positioned are separated from one another. The dicing process may be performed with a blade, a laser, or the like.

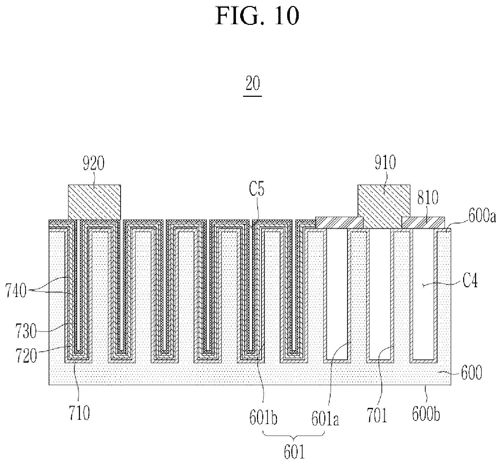

FIG. 10 is a drawing illustrating a capacitor 20 according to another embodiment.

Referring to FIG. 10, the capacitor 20 according to another embodiment may include a structure 600, a first internal electrode 710, a floating electrode 720, a second internal electrode 730, dielectric layers 740, a first external electrode 910, and a second external electrode 920.

The structure 600 has a first surface 600a and a second surface 600b positioned opposite to each other. In FIG. 10, it is shown that the first surface 600a is positioned on the upper side and the second surface 600b is positioned on the lower side. Accordingly, the first surface 600a may be referred to as the upper surface, and the second surface 600b may be referred to as the lower surface. Further, the direction in which the first surface 600a and the second surface 600b are spaced apart from each other may be referred to as a vertical direction. The structure of the structure 600 is identical or similar to that of the structure 100 of the capacitor 10 according to an embodiment, and thus a redundant description thereof will not be made.

The first internal electrode 710 is disposed on the inner surfaces of openings 601. Also, the first internal electrode 710 may be disposed on the sections between adjacent openings 601 on the first surface 600a of the structure 600. Accordingly, the regions of the first internal electrode 710 disposed on the inner surfaces of the openings 601 may be connected to each other by the regions position of the first surface 600a of the structure 600.

The openings 601 may include first openings 601a and second openings 601b. Among the plurality of openings 601, one or more are provided as first openings 601a. Further, the remaining openings of the plurality of openings 601 other than the first openings 601a may be provided as second openings 601b.

The first external electrode 910 may be disposed on the first surface (600a) side of the structure 600. The first external electrode 910 is disposed on the first internal electrode 710 in the region where the first openings 601a are positioned. The first external electrode 910 may face the region where the first openings 601a are positioned, in the vertical direction. The first external electrode 910 may be disposed so as to be in contact with the first internal electrode 710 in a region located adjacent to the first openings 601a, thereby being electrically connected to the first internal electrode 710. The first external electrode 910 may be a single-layer structure or a multi-layer structure.

The first external electrode 910 may be disposed on the first internal electrode 710 disposed on a section between first openings 601a. The first external electrode 910 may cover one or more first openings 601a. Accordingly, in the first openings 601a positioned below the first external electrode 910, first opening side cavities C4 may be formed on the first internal electrode 710. Further, on the portions of the region on the first openings 601a, other than the region where the first external electrode 910 is disposed, a first opening side insulating layer 810 may be disposed. The first opening side insulating layer 810 may be disposed so as to cover some of the first openings 601a. Accordingly, in the first openings 601a positioned below the first opening side insulating layer 810, first opening side cavities C4 may be formed on the first internal electrode 710.

On the first internal electrode 710 in the region where the second openings 601b are positioned, the floating electrode 720 may be disposed. In the region where the second openings 601b are positioned, the floating electrode 720 may be formed on the inner regions of the second openings 601b and the sections between the second openings 601b adjacent to each other on the first surface 600a of the structure 600.

The floating electrode 720 may not be on the first internal electrode 710 in the region where the first openings 601a are positioned. In other words, the floating electrode 720 may not be formed on the first openings 601a and the first internal electrode 710 disposed on the region on the first surface 600a between first openings 601a adjacent to each other.

On the floating electrode 720, the second internal electrode 730 is disposed. In other words, the second internal electrode 730 may be disposed on the region where the second openings 601b are positioned. In the region where the second openings 601b are positioned, the second internal electrode 730 may be formed on the inner regions of the second openings 601b and the sections on the first surface 600a of the structure 600 between the second openings 601b adjacent to each other. In the second openings 601b, second opening side cavities C5 may be formed on the second internal electrode 730. Alternatively, the second internal electrode 730 may be disposed so as to fill the second openings 601b, such that the second openings 601b do not have second opening side cavities C5.

The second internal electrode 730 is not on the first internal electrode 710 in the region where the first openings 601a are positioned.

The dielectric layers 740 are disposed only on some portions of the first internal electrode 710. The dielectric layers 740 may be disposed only on the region where the second openings 601b are positioned.

In the region where the second openings 601b are positioned, the dielectric layers 740 may be disposed between the first internal electrode 710 and the floating electrode 720. In the region where the second openings 601b are positioned, a dielectric layer 740 may be disposed between the floating electrode 720 and the second internal electrode 730.

The dielectric layers 740 may not be on the first internal electrode 710 in the region where the first openings 601a are positioned. In other words, the dielectric layers 740 may not be formed on the first openings 601a and the first internal electrode 710 disposed in the regions of the first surface 600a between the first openings 601a adjacent to each other.

The second external electrode 920 may be disposed on the first surface (600a) side of the structure 600. The second external electrode 920 is disposed on the second internal electrode 730. The second external electrode 920 may be disposed so as to be in contact with the second internal electrode 730, thereby being electrically connected to the second internal electrode 730. The second external electrode 920 may be disposed on the region where the second openings 601b are positioned, so as to face the region where the second openings 601b are positioned, in the vertical direction. The second external electrode 920 may be a single-layer structure or a multi-layer structure.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A capacitor comprising:
a structure that has a first surface where a plurality of openings are positioned;
a first internal electrode that is disposed on at least a portion of a region where the plurality of openings are positioned;
a floating electrode that is disposed on a partial region of the first internal electrode;
a second internal electrode that is disposed on the floating electrode;
a first external electrode that is disposed on the first surface and is connected to the first internal electrode; and
a second external electrode that is disposed on the first surface and is connected to the second internal electrode.

2. The capacitor of claim 1, wherein
the structure includes anodizing aluminum oxide, and/or wherein
the plurality of openings includes first openings, second openings, and third openings, and
the first external electrode faces a region where the first openings are positioned, in a direction in which the first surface of the structure and a second surface of the structure are spaced apart from each other.

3. The capacitor of claim 2, wherein
in the first openings, first opening side cavities are positioned, and/or
wherein
the first external electrode is connected to the first internal electrode in a region positioned adjacent to the first openings.

4. The capacitor of claim 3, wherein
the first external electrode is in direct contact with the first internal electrode so as to be connected to the first internal electrode.

5. The capacitor of claim 2, further comprising:
a first opening side insulating layer that covers the first openings, and/or wherein
the second external electrode faces a region where the second openings are positioned, in the direction in which the first surface and the second surface are spaced apart from each other.

6. The capacitor of claim 5, wherein
the second external electrode is connected to the second internal electrode in a region positioned adjacent to the second openings.

7. The capacitor of claim 6, wherein
the second external electrode is in direct contact with the second internal electrode so as to be connected to the second internal electrode.

8. The capacitor of claim 5, wherein
in the second openings, second opening side cavities are positioned, and/or further comprising:
a second opening side insulating layer that covers the second openings.

9. The capacitor of claim 8, wherein
the floating electrode and the second internal electrode are disposed on the second opening side insulating layer.

10. The capacitor of claim 2, wherein
among regions where the first, second, and third openings are positioned, the floating electrode and the second internal electrode are disposed only on the regions where the second openings and the third openings are positioned.

11. The capacitor of claim 1, wherein
the plurality of openings includes first openings and second openings, and
among regions where the first and second openings are positioned, the floating electrode and the second internal electrode are disposed only on the region where the second openings are positioned, and/or wherein
the number of openings among the plurality of openings where the first internal electrode is disposed is greater than the number of openings among the plurality of openings where the floating electrode and the second internal electrode are disposed.

12. A capacitor comprising:
a structure that has a first surface where a plurality of openings is positioned;
a first internal electrode that is disposed on regions between the plurality of openings on the first surface and the openings;
a floating electrode that is disposed on the first internal electrode;
a second internal electrode that is disposed on the floating electrode;
a first external electrode that is connected to the first internal electrode and is disposed in a direction toward which the first surface of the structure faces; and
a second external electrode that is connected to the second internal electrode and is disposed in the direction toward which the first surface of the structure faces.

13. The capacitor of claim 12, wherein
the plurality of openings includes first openings, second openings, and third openings, and
on the first openings and a region where the first openings are adjacent to each other, the floating electrode and the second internal electrode are not present; and
the first external electrode is connected to the first internal electrode in a region positioned adjacent to the first openings.

14. The capacitor of claim 13, further comprising:
a second opening side insulating layer that covers the second openings.

15. The capacitor of claim 12, wherein
the plurality of openings includes first openings and second openings, and
on the first openings and a region where the first openings are adjacent to each other, the floating electrode and the second internal electrode are not present; and
the first external electrode is connected to the first internal electrode in a region positioned adjacent to the first openings.
